# EUROPEAN PATENT SPECIFICATION

(11) **EP 4 153 353 B1**
(45) Date of publication and mention of the grant of the patent: **16.04.2025**
(21) Application number: 21725202.2
(22) Date of filing: 17.05.2021
(51) Int. Cl.: B01L 3/00, H05K 3/06

(54) **MANUFACTURING PROCEDURE FOR LABORATORY INTEGRATED ON A CHIP**
HERSTELLUNGSVERFAHREN FÜR EINEM AUF EINEM CHIP INTEGRIERTES LABOR
PROCÉDURE DE FABRICATION POUR UN LABORATOIRE INTÉGRÉ SUR UNE PUCE

(30) Priority: 21.05.2020 EP 20382430
(43) Date of publication of application: 29.03.2023
(73) Proprietor: Biothink Technologies S.L., 41092 Sevilla (ES)
(72) Inventor: FRANCO GONZÁLEZ, Emilio, 41092 Sevilla (ES); MOZO MULERO, Marta, 41092 Sevilla (ES)
(74) Representative: Herrero & Asociados, S.L.
(86) International application number: PCT/EP2021/062962
(87) International publication number: WO 2021/233814

(56) References cited:
- EP-A1- 2 468 403
- WO-A1-02/31505
- WO-A2-2006/081558
- CN-A- 110 487 873

## Description

### Technical field

The present invention belongs to the area of laboratories integrated on a chip (or lab-on-chips)
The invention is applied in areas such as health, veterinary, industrial, chemical, environmental, agri-food and pharmaceutical areas, by way of example. It can be used for PCR (polymerase chain reaction) devices, DNA analysis, parameter analysis systems, portable or not, such as creatinine or tumor markers, for measuring pH in fluids, for performing gas or pollutant sensors, for the manufacture of reactive or digester devices, the detection of compounds in foods, such as volatile compounds in olive oil or for the production and testing of drugs.

### Background of the invention

Lab-on-chips are booming due to their potential application in different sectors such as pharmaceutical or agri-food. One of the most interesting applications of these technologies is the manufacture of traditional analysis systems but on a miniaturized scale. This application has some improvements compared to traditional systems, such as the reduction in the amount of reagents required and of a significant part of the cost of the current analyzes; the automation of the processes using an attached electronics that affects the process in question choosing when each step of the process occurs and reading the result once it has been completed; faster analytics due to the reduction in the amount of fluids involved in the process; the possibility of making the entire system portable, so that analytics are allowed in places where an electrical connection is not available and, due to all the previous improvements, a reduction in the cost of the entire process. EP 2 468 403 A1 discloses a method for manufacturing a microfluidic deivce according to the state of the art.

In the future, these technologies will make it possible to replace traditional analytical systems, such as clinical laboratories or food analysis laboratories, reducing the cost of analytics that we know today by several orders of magnitude. This will also allow the elimination of second medical visits for the reading of results by a medical team to a patient.

The problems still pending in the manufacture of this type of device are due to the high cost of the materials used and of the manufacturing processes, which are also slow and difficult to industrialize and do not allow serial manufacturing processes.

### Summary of the invention

The invention consists of a fast, more economical and easily reproducible manufacturing process where the lab-on-chip is made up of successive layers of biocompatible material that integrate printed electronic circuits in biocompatible conductive material between layers, which connect actuators and sensors designed in the electronic circuit itself or embedded in contact with it, which are combined with a three-dimensional microchannel system that runs through the various layers or their intersections with all kinds of structures designed for the desired analysis functionalities, such as measuring chambers, filters, decanters, etc. The microchannels are connected to chambers for introducing fluids, such as chemical reagents or samples, which are driven by electronically controlled bidirectional pistons. Printed electronic circuits have external connections to other external electronic components or systems that can be used to supply, control or interpret the signals coming from the chip.

To solve the technological challenges necessary for the manufacture of such a chip, a layered manufacturing process has been designed where all the layers are made of a biocompatible material, such as, for example, without limitation, PMMA (polymethylmethacrylate), COC, polycarbonate, silicon, etc.

The manufacturing process includes metallizing those surfaces of biocompatible material in which it is desired to integrate bicompatible printed electronic circuits. Metallization is based on the adhesion of a prefabricated metal layer to the biocompatible substrate through the use of a resin. The resin is removed once the pattern of the tracks in the metal is generated by photolithography, so that the surface that will be in contact with the liquids or samples will be made of biocompatible polymer or metal. In this way, a metallized biocompatible substrate is achieved in which it is possible to generate printed circuits by traditional methods and add active electronic components within the biocompatible structure without having to resort to high-cost metals or highly specialized manufacturing methods.

In the different layers of biocompatible material, microchannels or holes are engraved, cut, drilled or stamped (by laser, for example), which, once the different layers or substrates of, for example, polymer, are joined, they make up the microchannels, house the electronic components, make up the drive system or define the physical separations of each area of the chip.

Like printed electronic circuits, the laboratory also includes electronic sensors and actuators built into the layers of the device. The sensors measure physical parameters such as temperature, pH, luminosity, etc. and they are linked to a mechanical drive system and an electronic board. The data recorded by the sensors is processed and interpreted in a processor. In this way, it is possible to carry out a control of the test conditions within the chip, measuring and operating on parameters such as temperature, or operating within the analytical process by means of, for example, light emitters or receivers. This is possible due to the fact that the contact of fluids with the metallic layer always takes place at points expressly designed for this purpose, the non-biocompatible electronic components being isolated inside watertight cavities and connected through the conductive layer.

### Brief description of drawings

To complement the description that is being made and in order to help a better understanding of the features of the invention, a set of figures is included as an integral part of said description where, by way of illustration and not limitation, the following has been represented:
Figure 1.- Plan view of a laboratory on chip according to the invention.

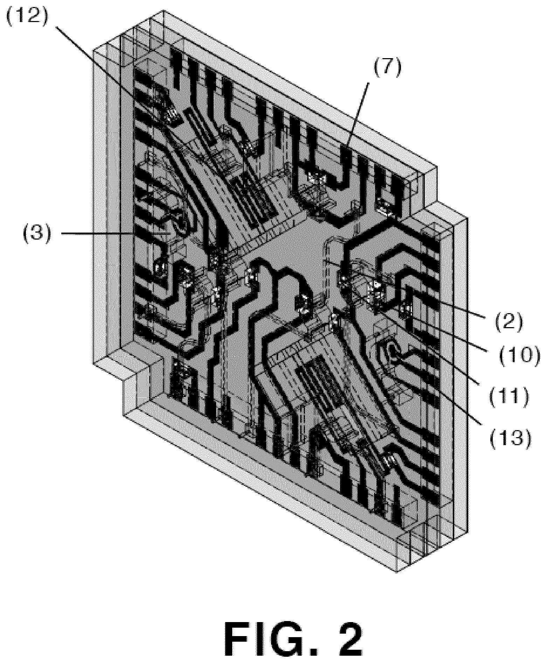

Figure 2.- 3D view of the laboratory according to the invention
Figure 3.- Plan [A] and section [B] view of a laboratory on chip of the invention.
Figure 4.- Sectional view of the manufacturing process of the upper layer of the microfluidic chip of Figure 3.
Figure 5.- Sectional view of the manufacturing process of the intermediate layer of the microfluidic chip of Figure 3.
Figure 6.- Sectional view of the manufacturing process of the lower layer of the microfluidic chip of Figure 3.
Figure 7.- Sectional view of the process for bonding the upper [A], intermediate [B] and lower [C] layers to give rise to the complete microfluidic chip [D]

### Description of the invention

The invention consists of a method to maufacture a laboratory integrated on a chip.

**The** laboratory has the following features:
a) One or several three-dimensional structures of biocompatible microchannels and susceptible to thermal processes limited by the melting temperature of the substrate material, which allow i) to perform on a simultaneous basis processes with different performance requirements on the same sample or different types of samples, ii) incorporate microfluidic processes that use physical effects that occur in three-dimensional structures such as decanting of particles in suspension in a fluid without incorporating filters or iii) physically section different areas of the chip to isolate them as required (chemical, thermal or optical insulation).
b) One or more biocompatible printed electronic circuits, which allow i) measuring and internally operating on microfluidic processes locally (only on one area of the chip), ii) heating only one area of the chip and making exact measurements on it without affecting the rest of the processes carried out therein, being able to transmit electrical signals in the desired areas of the chip, both to carry out electronic readings and to operate actuators (heaters, lights, sensors, etc.) integrated on the chip, iii) generating active structures such as heaters, electrodes or antennas using the electrical track design itself, iv) incorporating electronic components (sensors or actuators) connected to the electrical tracks within the chip itself, which are in contact with or very close to the fluids or areas that may require them, or v) ensuring complete electrical connectivity of the chip with any actuator, sensor or external controller.

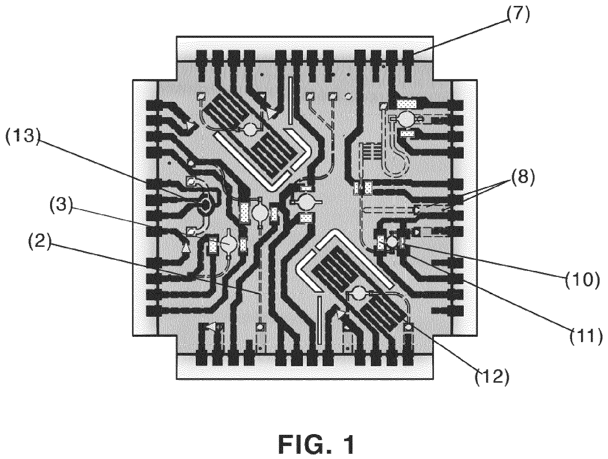

With reference to Figure 1, a laboratory on chip according to the invention is provided with multiple microchannels (2) in which measurement or reaction chambers (3) are located where analyzes are carried out. It also contains a printed electronic circuit (7) in which several thermal actuators have been defined in the form of heaters (12), several sensors in the form of electrodes (13) and electronic components (10) have been included. Fluidic processes such as mixing, filtering, decanting or heating of fluids will be carried out in the microchannels.

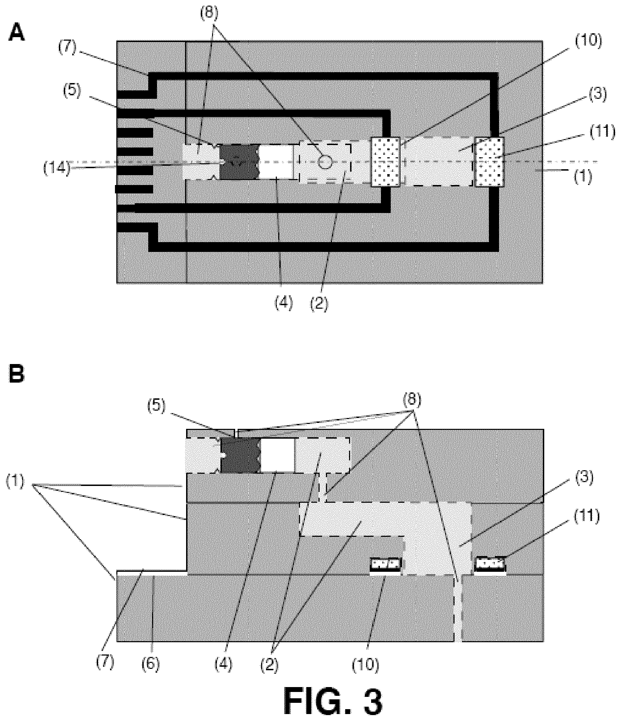

In Figure 3, a drive layer can be seen, wherein a fluid (4) separated from an external drive system (not shown in the figures) is encapsulated by means of a piston (5); an intermediate layer wherein the measurement or reaction chamber is located (3); and a metallic lower layer with a printed electronic circuit (7) on which there are electronic components, sensors (10) and actuators (11) that carry out measurements and the control of processes of the measurement and reaction chamber (3). All the microchannels (2) of the different layers are connected to each other and to the outside of the chip through holes (8). The printed electronic circuit communicates with the outside through electronic contacts (6) defined for this purpose.

The manufacturing method of the invention comprises, in a first step, the design by means of methods implemented by a complete chip processor with all the channels, circuits and actuators that it will require for a specific analytic. This design is carried out on a computer, for example, with a suitable program, such as AutoCAD^{®} and the like.

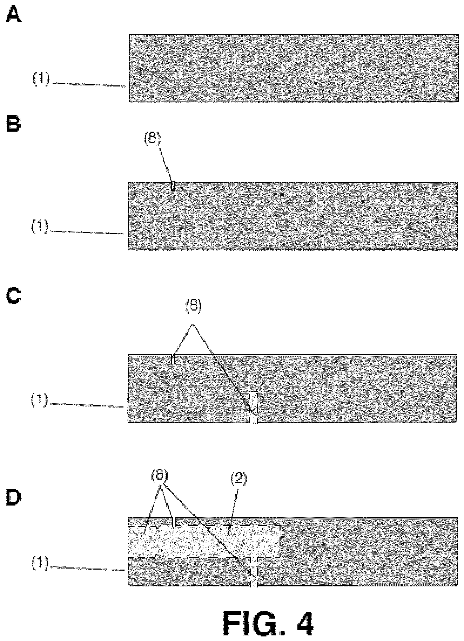

The manufacture of the upper layer as shown in Figure 4, begins with the use of the base material (1) from which a reduced-size part is obtained that is subsequently machining, for which some of the usable processes are CNC machining, laser ablation and injection molding of thermoplastic parts or hot embossing. By means of said machining the through holes (8, figures 4B, 4C) and the microchannels (2, figure 4D) joined by said holes are created.

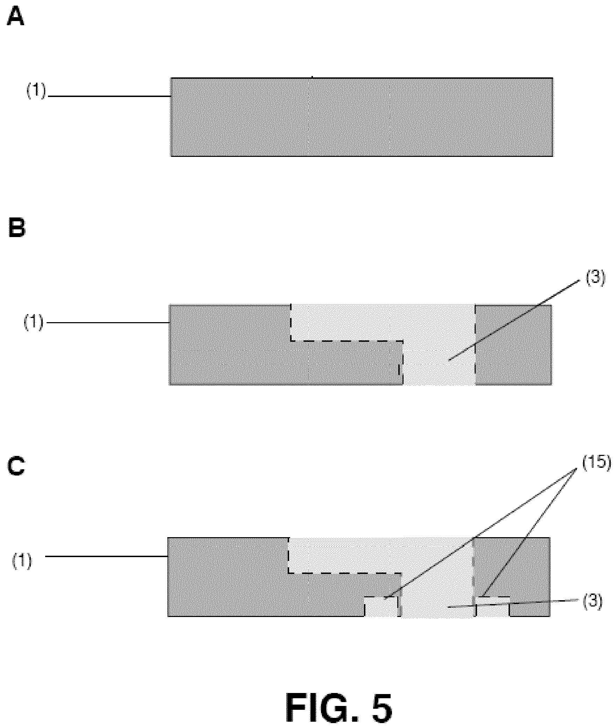

In Figure 5 the method of manufacturing the intermediate layer of the microfluidic chip of Figure 3 can be seen. In the method the measurement chambers (3) and also the cavities (15) that house the electronic components inside once the layers are bonded, are manufactured.

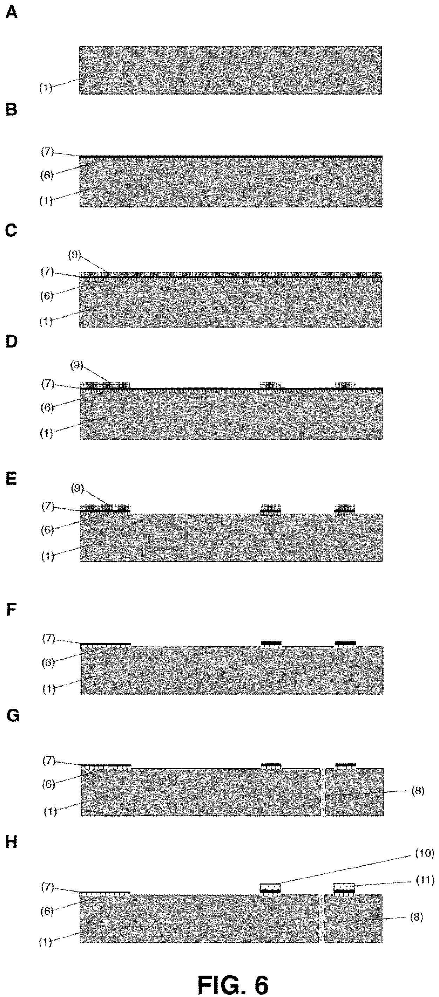

In Figure 6, the method of manufacturing the lower layer of the chip in Figure 3 can be seen. Starting [A] with a biocompatible substrate (1), the metallization process [B] is carried out, from which the printed circuit will emerge (7). A photoresin (9) is deposited on the metal layer [C] to allow performing a developing process by photolithography [D] and acid attack [E] to manufacture the biocompatible printed electronic circuit. Once the exposed bonding resin (6) has been removed [F], the necessary microchannels and through holes (8) [G] are manufactured. In this case there are only through holes (8).

Finally, before bonding the layers that make up the microfluidic chip, the actuators (10) and sensors (11) or heaters are placed on the areas of the chip designed for them [H]. In other implementations, heaters or antennas can be added.

More particularly, the biocompatible metal layer can be deposited by methods such as electroplating, sputtering, or adhering metal foil to the substrate. A functionalization process is carried out on this metallic layer by means of photolithography, firstly depositing a layer of photosensitive resin (6) that will be selectively activated by exposing specific areas of the surface using photosensitive resin sensitizing agents (ultraviolet, visible or infrared light depending on the type of photosensitive resin). Once the resin is exposed, the resin will be developed and the metal deposited on the sensitized areas of said resin by an etching or chemical etching process will be removed, generating a specific metallization pattern as previously set forth. Metallization is performed with a conductive biocompatible material such as aluminum, gold, titanium, ITO or nitinol, from the polymeric substrate of, for example, PMMA.

To carry out the metallization of the surface, firstly, we proceed to the cleaning and removal of possible residues from the polymeric surface with the help of volatile solvents such as ethanol or acetone, which evaporate quickly without leaving residues on the surface, which is also sterilized. Once cleaned, an adhesive resin, for example epoxy, is deposited, generating a uniform layer with a thickness in the order of tens of microns. The metallic foil is deposited on this still fresh layer and uniform pressure is applied over the entire surface to ensure the continuity of the layer. For this, several methods are used: applying pressure through the use of hot roll laminators or inserting the part into an automated hot plate press. The process requires a temperature between 65°C and 100°C for the specific curing of the resin, as well as a pressure exerted of between 0.5 to 3 tons for about 5 to 15 minutes.

The acid attack can be carried out with different solutions such as, for example, 37% fuming hydrochloric acid and hydrogen peroxide of 110 volumes in equal parts. This solution is capable of attacking metal without damaging the polymeric substrate, thereby leaving an electronic circuit printed on a polymeric surface whose exposed parts still have a layer of the adhesive resin used for metallization. This resin together with the bonding resin of the metallic layer that is exposed after the process are eliminated through the use of organic solvents such as acetone, isopropanol or ethanol, which attack the resins without damaging the base polymeric substrate or the printed electronic circuit.

Thus, there remains a part on which a specific metallic design will be obtained that can serve as the basis for the integration of electronic elements within the device and the transmission of electrical signals bidirectionally with the attached electronics system.

The closing piston (5) separates the encapsulated fluid (4) in the lab-on-chip from an external impulse mechanics that operates it through a mobile piston that is connected to a hole in the piston (14). It is possible that the piston operates the fluid in both directions, producing its impulse or suction. The movement of the piston is controlled by an external electronic system that is automated by means of specific software for the specific type of analysis to be performed.

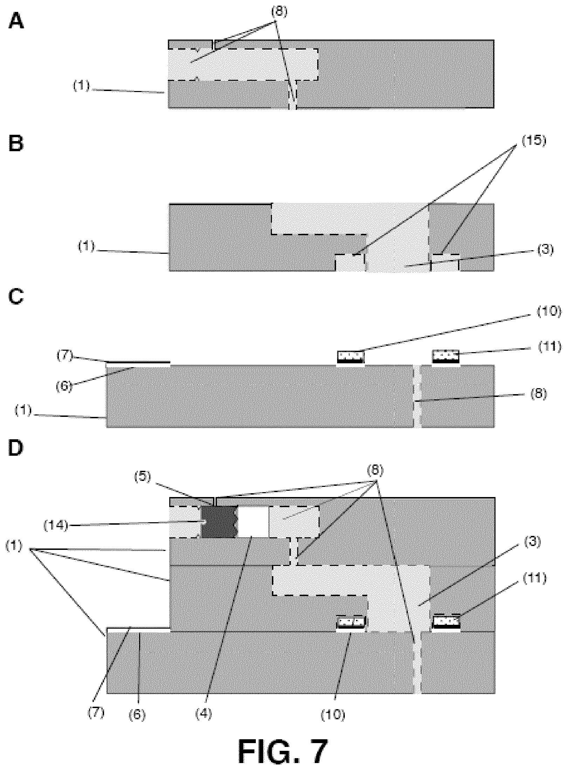

Joining of layers that make up the device (Figures 7A-7D) is made using organic solvents and the use of a combination of pressure and temperature, which may or may not be assisted by the additional use of adhesives. Through this manufacturing process the complete device with multiple layers is obtained as shown in Figure 7D.

The final device can have several polymer layers, even of different thicknesses between 1 and 10mm, with microchannels that are connected to each other by means of the chambers (3) designed for this purpose, and different printed electrical layers that may be connected by physically contacting each other on certain areas by overlapping layers or pathways.

By combining these structures, a series of functionalities can be performed that allow the study of certain parameters through the use of three widely used analytical techniques: the amplification and detection of genetic sequences by means of the polymerase chain reaction (or PCR), the detection and quantification of specific antibodies and antigens using the enzyme-linked absorption immunoassay technique (or ELISA) and the detection of biochemical parameters and ions through the use of electrodes or electrochemical detection. The data collected by the sensors will serve to monitor the progress of the fluids within the microchannels (2), and can be used to feed back the operation of the actuator and, therefore, perform precisely and safely controlled volume impulses or even vary the temperature of said liquid using Peltier cells, variable temperature resistances (NTCs) or thermal resistances. In addition, the communication of the data collected by these sensors, such as, for example, integrated thermal sensors (NTC) or optical actuators (LED) to an electronics attached to the actuator platform (not shown in the figures) will generate a closed circuit in which it can visualize, control and space-temporarily parameterize each of the actions of the mechanical system, as well as monitor the advance of fluids within the microchannels (2) in real time.

The laboratory is also provided with independent and active heating zones that can be heating tracks on the metallization layer (for those applications where the heating rate is not so high priority) or rapid heating cartridges.

In order to control those electronic components included in the laboratory and collect data from the laboratory's sensors, a series of contact electrodes have been configured that, through their connection to the central electronics, are capable of transmitting the information collected by sensors and measuring electrodes of the part comprising the microchannels and communicating them to the processor integrated in the analysis system.

By virtue of the use of inexpensive materials that are easy to manipulate or manufacture, such as PMMA, the metallization step by photolithography and the manufacture of the microchannels by laser engraving, micro-milling or hot embossing, it is possible to carry out the entire process on an industrial and serial basis.

By virtue of the creation of three-dimensional microfluidic lab-on-chip structures, being biocompatible and susceptible to thermal processes limited by the melting temperature of the substrate material (e.g. polymethylmethacrylate 105° or COC 160°) the following objectives are achieved:
a) To perform on a simultaneous basis different physical, chemical or biological processes with different performance requirements on the same sample or different types of samples.
b) To incorporate microfluidic processes that use physical effects that occur in three-dimensional structures such as decanting of particles in suspension in a fluid without incorporating filters.
c) To physically section different areas of the chip to isolate them as required (chemical, thermal or optical insulation).

By virtue of the fact that any area of the lab-on-chip can be converted into a biocompatible printed circuit, the following objectives are achieved:
a) To be able to measure and act internally on microfluidic processes locally (only on one area of the chip). To be able to heat only one area of the chip and make exact measurements on it without having to affect the rest of the processes carried out on it.
   To be able to transmit electrical signals in the desired areas of the chip, both to carry out electronic readings and to operate actuators (heaters, lights, sensors, etc.) integrated on the chip.
b) To generate active structures such as heaters, electrodes or antennas using the design of the electrical track itself.
c) To be able to incorporate electronic components (sensors or actuators) connected to the electrical tracks inside the chip itself, which are in contact with or very close to the fluids or areas that may require them, eliminating all maximum possible interfering with the operation or measurement.
d) To ensure complete electrical connectivity of the chip with any external actuator, sensor or controller.

## Claims

1. Method of layered manufacturing a lab-on-chip, comprising the following steps:
- designing, by means of a computer program, a printed circuit (7), mixing and reaction cavities (3) for fluids, microchannels (2) and spaces (15) for the placement of electronic components to be found in each layer;
- mechanizing in one or more biocompatible substrates the different voids and passages that will make up the mixing and reaction cavities (3), microchannels (2), holes (8) that join the microchannels and spaces for the subsequent placement of electronic components (15);
- metallizing with a biocompatible conductive material those surfaces in which the printed circuit (7) will be integrated according to the design made in the first step;
- generating the printed circuit (7) by photolithography and acid attack;
- bonding the electronic components in the corresponding spaces (15); wherein the electronic components are actuators (11) or sensors (10).
- joining all the layers that make up the final laboratory, wherein the metallization is carried out by the adhesion of a pre-elaborated biocompatible conductive material to the biocompatible substrate by means of a resin, the material being one or more of the following: aluminum, silver, gold, platinum, titanium, ITO, graphene or nitinol; and wherein the biocompatible substrate/s comprise/s one or more of the following materials: polymethylmethacrylate (PMMA), polyethylene terephthalate (PET), polydimethylsiloxane (PDMS), poly 3,4-ethylenedioxythiophene (PEDOT), copolymer of cyclic olefin (COC), polycarbonate, or silicon.

## Patentansprüche

1. Verfahren zur schichtweisen Herstellung eines Chiplabors, umfassend die folgenden Schritte:
- Gestalten einer gedruckten Schaltung (7), von Misch- und Reaktionshohlräumen (3) für Flüssigkeiten, von Mikrokanälen (2) und Leerräumen (15) für die Platzierung von elektronischen Komponenten, die in jeder Schicht zu finden sind, mittels eines Computerprogramms;
- mechanisches Herausarbeiten der verschiedenen Hohlräume und Durchgänge, die die Misch- und Reaktionshohlräume (3), Mikrokanäle (2), Löcher (8), die die Mikrokanäle und Leerräume (15) für die anschließende Platzierung von elektronischen Komponenten miteinander verbinden, bilden, in einem oder mehreren biokompatiblen Substraten;
- Metallisieren derjenigen Flächen, in denen die gedruckte Schaltung (7) gemäß der im ersten Schritt angefertigten Gestaltung integriert wird, mit einem biokompatiblen leitfähigen Material;
- Erzeugen der gedruckten Schaltung (7) durch Photolithographie und Säureangriff;
- Bonden der elektronischen Komponenten in den entsprechenden Leerräumen (15); wobei die elektronischen Komponenten Aktoren (11) oder Sensoren (10) sind;
- Zusammenfügen aller Schichten, die das fertige Labor bilden sollen, wobei die Metallisierung durch die Anhaftung eines vorverarbeiteten biokompatiblen leitfähigen Materials an dem biokompatiblen Substrat mittels eines Harzes durchgeführt wird, wobei es sich bei dem Material um eines oder mehrere der folgenden handelt: Aluminium, Silber, Gold, Platin, Titan, Indiumzinnoxid, Graphen oder Nitinol; und wobei das oder die biokompatiblen Substrate eines oder mehrere der folgenden Materialien umfassen: Polymethylmethacrylat (PMMA), Polyethylenterephthalat (PET), Polydimethylsiloxan (PDMS), Poly-3,4-ethylendioxythiophen (PEDOT), Copolymer eines cyclischen Olefins (COC), Polycarbonat oder Silicium.

## Revendications

1. Méthode de fabrication en couches d'un laboratoire sur puce (lab-on-chip), comprenant les étapes suivantes :
- Conception, à l'aide d'un programme informatique, d'un circuit imprimé (7), de cavités de mélange et de réaction (3) pour les fluides, de microcanaux (2) et d'espaces (15) pour le placement des composants électroniques dans chaque couche ;
- Usinage dans un ou plusieurs substrats biocompatibles des différentes cavités et passages qui constitueront les cavités de mélange et de réaction (3), les microcanaux (2), les trous (8) reliant les microcanaux et les espaces pour le placement ultérieur des composants électroniques (15) ;
- Métallisation avec un matériau conducteur biocompatible des surfaces où le circuit imprimé (7) sera intégré, conformément à la conception réalisée lors de la première étape ;
- Génération du circuit imprimé (7) par photolithographie et gravure acide ;
- Fixation des composants électroniques dans les espaces correspondants (15), dans laquelle ces composants sont des actionneurs (11) ou des capteurs (10) ;
- Assemblage de toutes les couches constituant le laboratoire final, dans lequel la métallisation est réalisée par l'adhésion d'un matériau conducteur biocompatible préfabriqué au substrat biocompatible à l'aide d'une résine, le matériau étant choisi parmi les suivants : aluminium, argent, or, platine, titane, ITO, graphène ou nitinol ; et dans lequel le(s) substrat(s) biocompatible(s) comprennent un ou plusieurs des matériaux suivants : polyméthacrylate de méthyle (PMMA), polyéthylène téréphtalate (PET), polydiméthylsiloxane (PDMS), poly(3,4-éthylènedioxythiophène) (PEDOT), copolymère d'oléfine cyclique (COC), polycarbonate ou silicium.
